(19) Europäisches Patentamt
European Patent Office
Office européen des brevets

(11) **EP 4 086 640 B1**

(12) **EUROPÄISCHE PATENTSCHRIFT**

(45) Veröffentlichungstag und Bekanntmachung des Hinweises auf die Patenterteilung:
**26.02.2025 Patentblatt 2025/09**

(21) Anmeldenummer: **21172444.8**

(22) Anmeldetag: **06.05.2021**

(51) Internationale Patentklassifikation (IPC):
**G01R 19/25** (2006.01)

(52) Gemeinsame Patentklassifikation (CPC):
**G01R 19/2509**

(54) **UNIVERSELLER MESSEINGANG ZUM ANSCHLUSS EINES KLEINSIGNALWANDLERS UND ELEKTRISCHES GERÄT MIT EINEM SOLCHEN MESSEINGANG**

UNIVERSAL MEASURING INPUT FOR CONNECTING A SMALL SIGNAL CONVERTER AND ELECTRICAL APPARATUS WITH SUCH A MEASURING INPUT

ENTRÉE DE MESURE UNIVERSELLE PERMETTANT DE RACCORDER UN PETIT CONVERTISSEUR DE SIGNAL ET APPAREIL ÉLECTRIQUE DOTÉ D'UNE TELLE ENTRÉE DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.11.2022 Patentblatt 2022/45**

(73) Patentinhaber: **Siemens Aktiengesellschaft
80333 München (DE)**

(72) Erfinder:
• **Jurisch, Andreas
16727 Schwante (DE)**
• **Werben, Stefan
91207 Lauf a.d.P. (DE)**

(74) Vertreter: **Siemens Patent Attorneys
Postfach 22 16 34
80506 München (DE)**

(56) Entgegenhaltungen:
DE-A1- 10 346 356      US-A1- 2019 383 859
US-B2- 9 917 662

**Beschreibung**

Die Erfindung betrifft einen Messeingang zum Anschluss eines Kleinsignalwandlers an ein elektrisches Gerät mit einem elektrischen Eingang zum Anschließen einer Anschlussleitung des Kleinsignalwandlers, einem elektrischen Ausgang zur Ausgabe eines Messignals an das elektrische Gerät und mit einem Korrekturglied, das einen digitalen Filter aufweist, dessen Filter-Übertragungsfunktion an den Kleinsignalwandler angepasst ist.

Die Erfindung betrifft auch ein elektrisches Gerät mit einem solchen Messeingang.

Heutzutage im Gebrauch befindliche elektrische Geräte, beispielsweise Automatisierungs-, Mess-, Steuer- oder Schutzgeräte einer technischen Anlage (z.B. einem Energieversorgungsnetz) weisen üblicherweise einen oder mehrere Messeingänge auf, an die eine Sekundärseite von Wandlern bzw. Sensoren angeschlossen werden können, um Messgrößen wie Ströme oder Spannungen der technischen Anlage erfassen zu können. Dabei sind diese Messeingänge üblicherweise spezifisch an den Typ und die spezielle Ausgestaltung des Wandlers angepasst. Über Jahrzehnte hinweg waren induktive Wandler sowohl zur Stromals auch zur Spannungsmessung gängig. Mit dem Aufkommen sogenannter Kleinsignalwandler (im Englischen auch als "Low Power Instrument Transformer" LPIT bezeichnet), die beispielsweise gemäß dem Standard IEC 61869 ausgestaltet sind, steigt die Anzahl an neuen Sensortypen und damit der Aufwand zur Bereitstellung geeigneter Messeingänge signifikant an. Beispiele von Kleinsignalwandlern sind Rogowskispulen, induktive Wandler mit integrierter Bürde, kapazitive Teiler, resistive Teiler und kompensierte RC-Teiler. Weiterhin können CR-Teiler mit passivem Integrator (siehe z.B. IEC 61869-11 Anhang 11C, Bild 11C.1) oder ein einfache Messkondensatoren zur Verschiebestrommessung (sogenannte "Field Probes") zur Spannungsmessung eingesetzt werden. Zur Strommessung können neben den in der IEC 61869-10 beschriebenen passiven Kleinsignalwandlern auch Sensoren eingesetzt werden, die auf der Anwendung des Magnetoresistiven Effektes oder des Halleffektes beruhen. Bei diesen Sensoren wird wiederum zwischen direkt abbildenden und Kompensationstypen unterschieden.

Wenn ein Gerätehersteller nun für jeden Sensortyp einen eigenen spezifischen Messeingang anbieten wollte, müsste eine Vielzahl unterschiedlicher Baugruppen entwickelt und vorgehalten werden, um alle möglichen Kombinationen von Sensortypen und Sensorbauweisen abdecken zu können.

Zum Vergleich sei erwähnt, dass für herkömmliche induktive Wandler ein einzelner standardisierter Messeingang ausreicht, um Kompatibilität zwischen den Strom- bzw. Spannungswandlern und den jeweiligen Gerätesignaleingängen zu gewährleisten. Für die neuen Kleinsignalwandler existieren verschiedene Stromsensortypen (z.B. Rogowskispule, Kleinleistungs-Stromwandler ("Low Power CT's") mit integriertem Bürdenwiderstand) und verschiedene Spannungssensortypen (kapazitiver Teiler, resistiver Teiler, kompensierter RC-Teiler, Field Probes und CR-Teiler mit passivem Integrator). Jeder dieser Sensortypen kann für verschiedene Lastimpedanzen ausgestaltet werden und jede dieser Varianten würde einen eigenen Messeingang erfordern, so dass zur Abdeckung jeder dieser Varianten eine Vielzahl unterschiedlicher Messeingänge vorhanden sein müsste.

Aus der DE 103 46 356 A1 ist ein Spannungseingang zum Anschluss eines Kleinsignalwandlers in Form eines kapazitiven Teilers bekannt. Zur Korrektur einer Übertragungsfunktion des kapazitiven Teilers wird ein Filter mit einer zur Übertragungsfunktion inversen Korrekturfunktion verwendet. Um den bekannten Messeingang auch an einen herkömmlichen induktiven Wandler anschließen zu können, kann der Filter überbrückt werden.

Weitere Messeingänge gemäß dem Stand der Technik sind in der US 9 917 662 B2 und der US 2019/383859 A1 beschrieben.

Ausgehend von einem Messeingang der eingangs genannten Art liegt der Erfindung die Aufgabe zugrunde, einen Messeingang zur Verfügung zu stellen, mit dem alle möglichen Typen von Kleinsignalwandlern, insbesondere solchen Kleinsignalwandlern, die entsprechend dem Standard IEC 61869 ausgebildet sind, an ein elektrisches Gerät angeschlossen werden können und so die Gerätevielfalt von bereitzustellenden Messeingängen reduziert werden kann.

Zur Lösung dieser Aufgabe wird ein gattungsgemäßer Messeingang vorgeschlagen, bei dem die Filter-Übertragungsfunktion des Korrekturglieds mittels eines Parametersatzes festgelegt ist, wobei der Parametersatz spezifisch für den Kleinsignalwandler variabel vorgebbar ist.

Der Vorteil des erfindungsgemäßen Messeingangs liegt darin, dass die Anpassung quasi über einen Korrekturfilter erfolgt, dessen Übertragungsfunktion mittels eines Parametersatzes variabel vorgegeben werden kann. Somit kann der Messeingang universell für jeden der unterschiedlichen Sensortypen in einfacher Weise über den Parametersatz spezifisch angepasst werden. Der Parametersatz kann hierbei Parameter enthalten, die zur Festlegung der Filter-Übertragungsfunktion herangezogen werden können. Beispiele solcher Parameter sind die Eigenschaften der angeschlossenen Kleinsignalwandler, eventuell verwendeter Adapter und der Anschlussleitungen. Diese Eigenschaften der Sensoren lassen sich z.B. für Stromsensoren mit den in Tabelle 1004 "Designation of a passive CT" der IEC 61869-10 angegebenen Bemessungswerten beschreiben. Für Spannungssensoren können diese Eigenschaften mit den Bemessungswerten aus Tabelle 1106 "Bezeichnung eines Passiven LPCT" der IEC 61869-11 beschrieben werden. Alternativ kann eine Beschreibung der Eigenschaften eines Kleinsignalwandlers durch Angabe der Werte des Ersatzschaltbildes der Sensoren, Adapter und Kabel erfolgen. Aus den Parametern lässt sich bei Kenntnis der gewünschten resultierenden Gesamt-Übertragungsfunktion schließlich die benötigte Filter-Übertragungsfunktion ermitteln.

Erfindungsgemäß ist der Parametersatz spezifisch für verschiedene Typen von Kleinsignalwandlern einerseits zur Strommessung und andererseits zur Spannungsmessung vorgebbar.

Somit kann ein und derselbe Messeingang variabel nicht nur für die Messung von Strom- oder Spannungssignalen verwendet werden, sondern er kann - abhängig vom vorgegebenen Parametersatz - sowohl zur Messung von Strömen als auch von Spannungen zum Einsatz kommen, ohne dass hierfür eine unterschiedliche Hardware-Baugruppe vorgehalten werden muss.

Eine weitere vorteilhafte Ausführungsform sieht vor, dass die Filter-Übertragungsfunktion des Korrekturglieds zur Kompensation einer Sensorstrecken-Übertragungsfunktion einer durch den Kleinsignalwandler, die Anschlussleitung und zumindest eine Baugruppe des Messeingangs gebildeten Übertragungsstrecke ausgebildet ist.

Gemäß dieser Ausführungsform wird die Genauigkeit der Messung dadurch erhöht, dass die Korrektur nicht nur hinsichtlich einer Übertragungsfunktion des Kleinsignalwandlers durchgeführt wird. Vielmehr werden in die Korrektur auch die Anschlussleitung, mit der der Kleinsignalwandler an den Messeingang angeschlossen ist, und wesentliche Baugruppen des Messeingangs selbst einbezogen. Die letztgenannten Komponenten können nämlich ebenfalls signifikante Einflüsse auf die Übertragung der Messignale haben. Hinsichtlich der Anschlussleitungen können insbesondere auch Aspekte der Anschlusstechnik (Verbindung Sensor nach einer Geräteklemme) Einfluss auf die benötigte Korrektur haben: z.B. können Kabel mit unterschiedlichen Längen, unterschiedliche Kabeltypen und diverse Adapter signifikante Einflüsse auf die benötigte Korrektur haben.

Eine weitere vorteilhafte Ausführungsform des erfindungsgemäßen Messeingangs sieht zudem vor, dass die Filter-Übertragungsfunktion derart ausgebildet ist, dass eine aus der Überlagerung der Sensorstrecken-Übertragungsfunktion und der Filter-Übertragungsfunktion resultierende Gesamt-Übertragungsfunktion einer Übertragungscharakteristik entspricht, die bei Verwendung eines (herkömmlichen) induktiven Wandlers als Sensor vorliegen würde.

Auf diese Weise kann gewährleistet werden, dass sich der an einen Kleinsignalwandler angeschlossene Messeingang aus Sicht des elektrischen Gerätes so verhält, als sei ein "normaler" induktiver Wandler angeschlossen. Damit können alle das Messignal verwendenden Funktionen ohne zusätzliche Anpassungen weiterverwendet werden.

Im Rahmen einer weiteren vorteilhaften Ausführungsform kann vorgesehen sein, dass die Polstellen der Filter-Übertragungsfunktion in Abhängigkeit der Lage der Nullstellen der Sensorstrecken-Übertragungsfunktion und die Nullstellen der Filter-Übertragungsfunktion in Abhängigkeit der Lage der Polstellen der Sensorstrecken-Übertragungsfunktion festgelegt sind.

Auf diese Weise lässt sich die zur Korrektur verwendete Filter-Übertragungsfunktion besonders vorteilhaft erzeugen, da die analytisch einfach zu ermittelnden Null- und Polstellen der Sensorstrecken-Übertragungsfunktion quasi als Ankerpunkte zur Ermittlung der Filter-Übertragungsfunktion verwendet werden.

Gemäß einer weiteren vorteilhaften Ausführungsform ist vorgesehen, dass der sensorspezifische Parametersatz in einem Datenspeicher im Rahmen einer Konfiguration des Messeingangs abgespeichert ist.

Konkret kann in diesem Zusammenhang vorgesehen sein, dass im Datenspeicher des Messeingangs oder in einem Konfigurationswerkzeug zur Konfiguration ein den Kleinsignalwandler beschreibendes Sensormodell, ein die Anschlussleitung beschreibendes Kabelmodell und ein zumindest eine Baugruppe des Messeingangs beschreibendes Messeingangsmodell bereitstellt sind, aus denen der sensorspezifische Parametersatz abgeleitet wird.

Die jeweiligen Modelle können hierbei eine mathematische Nachbildung der jeweiligen frequenzabhängigen Übertragungsfunktionen der einzelnen Komponenten darstellen. Jede der Komponenten wird als Block, beispielsweise als sogenannter "Vierpol" mit eigenen Eigenschaften angesehen, wobei durch Verknüpfung der einzelnen Blöcke die Sensorstrecken-Übertragungsfunktion gebildet wird. Aus dieser kann schließlich der Parametersatz abgeleitet werden, der zur Festlegung der Filter-Übertragungsfunktion dient.

Eine weitere vorteilhafte Ausführungsform sieht vor, dass dem elektrischen Eingang eine Impedanzanpassungs-Schaltung nachgeordnet ist, die als Spannungsteiler ausgebildet ist.

Hierdurch kann der Messeingang so ausgestaltet werden, dass eine erforderliche Eingangsimpedanz bereitgestellt wird. Beispielsweise sind in der Norm IEC 61869-10 oder IEC 61869-11 Eingangsimpedanzen von Messeingängen für Kleinsignalwandler vorgegeben, die durch eine solche Impedanzanpassungs-Schaltung eingehalten werden können.

Außerdem kann vorgesehen sein, dass der Impedanzanpassungs-Schaltung eine Signalaufbereitungseinheit nachgeschaltet ist, die zwischen einem ersten Modus gemäß einer Tiefpass-Charakteristik oder einem PI-Glied und einem zweiten Modus gemäß einer proportionalen Charakteristik umschaltbar ist.

Durch die Signalaufbereitungseinheit kann eine Anpassung des Messeingangs an den Typ des Kleinsignalwandlers erfolgen, so dass die Filter-Übertragungsfunktion einfacher ausgestaltet werden kann. Außerdem findet z.B. eine Kompression des erforderlichen Dynamikbereiches über die Frequenz statt, indem das Übertragungsverhalten der Signalaufbereitungseinheit einen großen Dynamikumfang der frequenzabhängigen Verstärkungen der Sensorstrecken-Übertragungsfunktion innerhalb des interessierenden Passbandes auf einen möglichst frequenzunabhängigen Wert kompensiert. Das wird bei Sensoren mit differenzierendem Verhalten z.B. mit einem Tiefpass oberhalb der Cut-Off Frequenz des Tiefpasses erreicht.

Konkret kann in diesem Zusammenhang vorgesehen sein, dass der Modus der Signalaufbereitungseinheit in Abhängigkeit von der Lage einer Nullstelle der Übertragungsfunktion des Kleinsignalwandlers festgelegt ist.

Beispielsweise kann hierzu vorgesehen sein, dass die Signalaufbereitungseinheit im ersten Modus arbeitet, wenn die Übertragungsfunktion des Kleinsignalwandlers eine Nullstelle bei f=0Hz aufweist, um eine differenzierende Charakteristik des eingesetzten Wandlers (z.B. Rogowskispule) auszugleichen.

Eine weitere vorteilhafte Ausführungsform des erfindungsgemäßen Messeingangs sieht vor, dass der Signalaufbereitungseinheit ein programmierbarer Verstärker nachgeschaltet ist.

Hierdurch kann die unterschiedliche Verstärkung verschiedener Kleinsignalwandler an den Messbereich des nachgeschalteten A/D Wandlers angepasst werden. Die Verstärkungsstufen des programmierbaren Verstärkers werden vorteilhafterweise logarithmisch gestaffelt, um eine optimale Anpassung des Messeingangs an die Verstärkung der Kleinsignalwandler zu erreichen. Mit anderen Worten können Kleinsignalwandler unterschiedlicher Übersetzungsverhältnisse existieren (d.h., es werden sich je nach primärem Nennstrom unterschiedliche sekundäre Nennwerte ergeben). Um dies abbilden zu können, werden unterschiedliche Messbereiche / Verstärkungsumschaltungen benötigt, die mit dem Verstärker realisiert werden können.

Zur Digitalisierung des Messignals kann schließlich vorgesehen sein, dass dem programmierbaren Verstärker eine Abtasteinrichtung bzw. ein A-D-Wandler nachgeschaltet ist.

Die Erfindung betrifft auch ein elektrisches Gerät mit zumindest einem Messeingang nach einem der Ansprüche 1-12. Bei einem solchen elektrischen Gerät kann es sich z.B. um ein Automatisierungs-, Mess-, Steuer- oder Schutzgerät einer technischen Anlage, beispielsweise eines Energieversorgungsnetzes, handeln.

Hinsichtlich des erfindungsgemäßen Gerätes gelten alle zu dem erfindungsgemäßen Messeingang voranstehend und nachfolgend gemachten Ausführungen und umgekehrt in entsprechender Weise, insbesondere kann das erfindungsgemäße Gerät mit dem Messeingang in jeder beliebigen Ausführungsform oder einer Kombination beliebiger Ausführungsformen betrieben werden. Auch hinsichtlich der Vorteile des erfindungsgemäßen Gerätes wird auf die zu dem erfindungsgemäßen Messeingang beschriebenen Vorteile verwiesen.

Gemäß einer vorteilhaften Ausführungsform des elektrischen Gerätes kann vorgesehen sein, dass das elektrische Gerät außer dem zumindest einen Messeingang zumindest einen weiteren Messeingang zum Anschluss eines induktiven Wandlers aufweist.

Insbesondere für den Fall, dass mit dem an einen Kleinsignalwandler angeschlossenen Messeingang die Charakteristik eines an einen induktiven Wandler angeschlossenen "herkömmlichen" Messeingangs nachgebildet wird, kann so gewährleistet werden, dass alle nachgeschalteten Gerätefunktionen des elektrischen Gerätes ohne weitere Anpassung und in den festgelegten Spezifikationen an die Art des Wandlers arbeiten können.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Messeingangs und des erfindungsgemäßen Gerätes in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1  ein mittels eines Kleinsignalwandlers an eine technische Anlage angeschlossenes elektrisches Gerät mit einem Messeingang;

Figur 2  eine schematische Darstellung einzelner Komponenten von Übertragungsfunktionen einer Messstrecke;

Figur 3  ein Ausführungsbeispiel eines Messeingangs;

Figur 4  ein einerseits mittels eines Kleinsignalwandlers und andererseits mittels eines induktiven Wandlers an eine technische Anlage angeschlossenes elektrisches Gerät; und

Figur 5  Beispiele einer Sensorstrecken-Übertragungsfunktion und einer Filter-Übertragungsfunktion.

In den Figuren sind identische oder einander entsprechende Einheiten mit denselben Bezugszeichen gekennzeichnet.

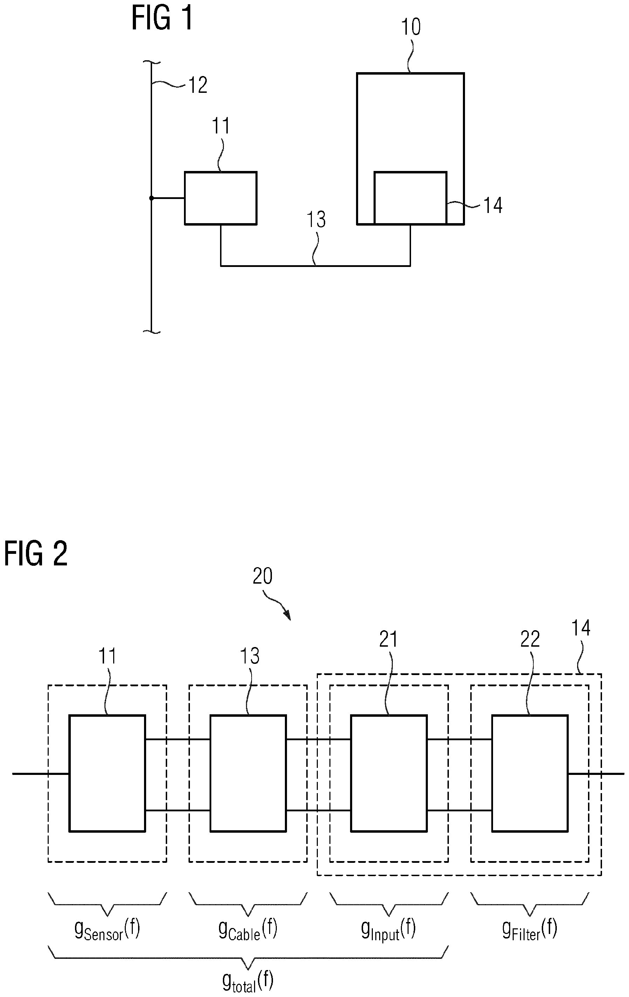

Figur 1 zeigt ein elektrisches Gerät 10, bei dem es sich z.B. um ein Automatisierungs-, Mess-, Steuer- oder Schutzgerät handeln kann. Solche Geräte dienen üblicherweise dazu, technische Anlagen zu beobachten, zu steuern, zu schützen oder zu überwachen. Zu diesem Zweck sind die Geräte über Sensoren an die technische Anlage angeschlossen, mit denen Messsignale aufgenommen werden, die den Status der technischen Anlage angeben. Bei der technischen Anlage kann es sich z.B. um ein elektrisches Energieversorgungsnetz handeln. Zur Überwachung eines solchen elektrischen Energieversorgungsnetzes werden üblicherweise Messsignale von Strömen und Spannungen aufgenommen. Während hierfür seit langer Zeit als Sensoren induktive Messwandler eingesetzt werden, wird inzwischen die Verwendung von Kleinsignalmesswandlern immer verbreiteter. Als Kleinsignalmesswandler werden Sensoren angesehen, die an ihrem Ausgang eine (im Vergleich zu herkömmlichen induktiven Wandlern) geringe elektrische Leistung ausgeben. Beispiele für Kleinsignalwandler zur Messungen von Strömen oder Spannungen sind Rogowskispulen, kapazitive Teiler, resistive Teiler, kompensierte RC-Teiler, CR-Teiler mit passivem Integrator oder Kleinleistungs-Stromwandler mit integrierter Bürde. Solche Kleinsignalwandler weisen meist eine andere Übertragungscharakteristik als die induktiven Wandler auf, was sich insbesondere in Bereichen hoher und niedriger Frequenzen zeigt.

In dem Beispiel der Figur 1 ist das elektrische Gerät 10 über einen Kleinsignalwandler 11 mit der technischen Anlage 12 verbunden. Bei der technischen Anlage 12 handelt es sich beispielhaft um ein elektrisches Energieversorgungsnetz, von dem in Figur 1 der Übersichtlichkeit halber nur eine Leitung dargestellt ist. Der Kleinsignalwandler 11 ist über eine Anschlussleitung 13, bei der es sich z.B. um ein doppelt geschirmtes Adernpaar mit einer in technischen Anlagen (z.B. Umspannwerken) üblichen Länge (z.B. wenige Meter in Mittelspannungs-Schaltanlagen bis mehrere 100m in Hochspannungsschaltanlagen) handeln kann, mit einem Messeingang 14 des elektrischen Gerätes 10 verbunden. Der Messeingang 14 kann hierfür beispielsweise eine integrierte Einbaukarte des elektrischen Gerätes 10 darstellen. Alternativ kann es sich aber auch eine separate Baugruppe handeln, die außerhalb des Gerätes 10 angeordnet ist. Der Messeingang 14 ist dazu eingerichtet, mit beliebigen Kleinsignalwandlern zusammenzuwirken. Hierfür weist er einen digitalen Filter auf, dessen Übertragungsfunktion die Charakteristik einer aus Kleinsignalwandler 11, Anschlussleitung 13 und zumindest einer Baugruppe des Messeingangs 14 gebildeten Sensorstrecken-Übertragungsfunktion in gewünschter Weise kompensiert.

Hierzu zeigt Figur 2 schematisch die einzelnen Komponenten einer Messstrecke 20 inklusive ihrer verschiedenen Übertragungsfunktionen. Die Messstrecke setzt sich aus dem Kleinsignalwandler 11, der Anschlussleitung 13 und dem Messeingang 14 zusammen, wobei der Messeingang zumindest eine Baugruppe 21 und ein Korrekturglied 22 mit dem oben erwähnten digitalen Filter aufweist. Dabei umfasst die zumindest eine Baugruppe 21 des Messeingangs 14 alle analogen Schaltungen des Messeingangs 14 bis zu einer Analog-Digital-Wandlung. Diese analogen Schaltungen dienen zur Vorverarbeitung (z.B. Filterung, Verstärkung) des Messsignals.

Jede der Komponenten der Messstrecke 20 besitzt eine eigene Übertragungsfunktion, also im Frequenzbereich eine Charakteristik, wie Ströme und Spannungen bezüglich ihrer Amplitude (Dämpfung) und ihres Phasenwinkels (Phasendrehung) frequenzabhängig übertragen werden. Konkret weist der Kleinsignalwandler 11 eine Übertragungsfunktion $g_{Sensor}(f)$, die Anschlussleitung 13 eine Übertragungsfunktion $g_{Cable}(f)$ und die zumindest eine Baugruppe 21 des Messeingangs 14 eine Übertragungsfunktion $g_{Input}(f)$. Diese Komponenten bilden gemeinsam eine Sensorstrecke und weisen eine sich aus den drei einzelnen Übertragungsfunktionen zusammengesetzte Sensorstrecken-Übertragungsfunktion $g_{total}(f)$ auf. Das Korrekturglied 22 mit dem digitalen Filter weist eine Übertragungsfunktion $g_{Filter}(f)$ auf, die zur Korrektur der Sensorstrecken-Übertragungsfunktion dient, so dass sich die Charakteristiken der einzelnen Komponenten der Sensorstrecke, z.B. Art und Bauweise des Kleinsignalwandlers, Nenn-Abschlussimpedanz (Designbürde) des Kleinsignalwandlers sowie Art und Länge der Anschlussleitungen, nicht auf das Messergebnis auswirken. Um beliebige Kleinsignalwandler mit beliebigen Anschlussleitungen als Sensoren zur Strom- oder Spannungsmessung verwenden zu können, kann die Filter-Übertragungsfunktion $g_{Filter}(f)$ zudem beliebig an die jeweilige Sensorstrecken-Übertragungsfunktion angepasst werden.

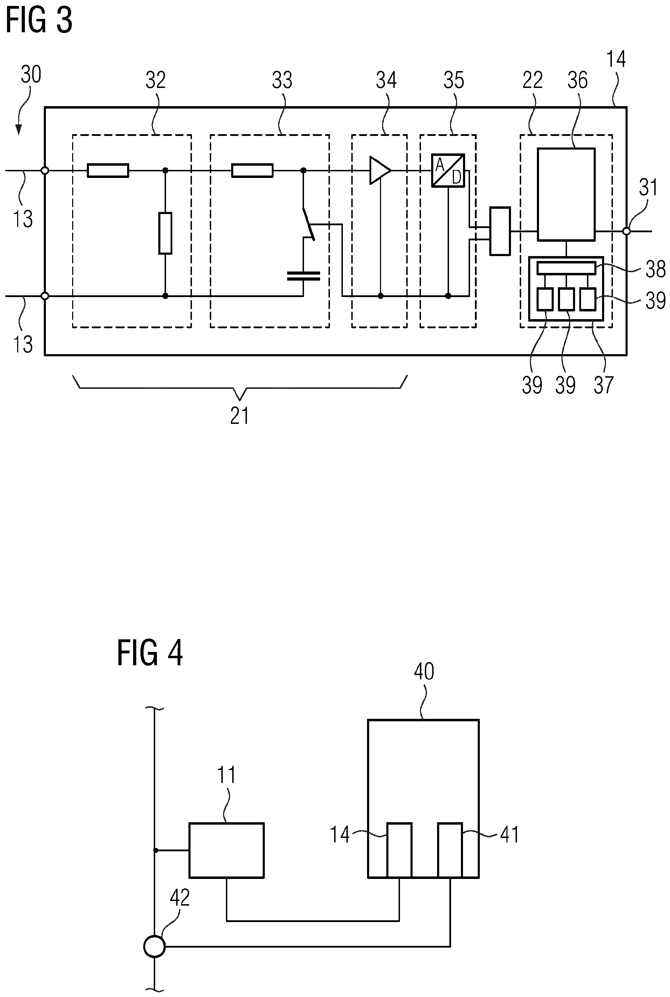

Figur 3 zeigt eine schematische Ansicht des Messeingangs 14. Der Messeingang 14 weist einen elektrischen Eingang 30 und einen elektrischen Ausgang 31 auf. Der elektrische Eingang 14 ist zur elektrischen Verbindung mit den Anschlussleitungen 13 eingerichtet, um den Messeingang 14 mit dem Kleinsignalwandler zu verbinden. Dem elektrischen Eingang 30 ist eine Impedanzanpassungs-Schaltung 32 nachgeordnet, die zur Anpassung der Eingangsimpedanz des Messeingangs 14 dient. Eingangsimpedanzen für Messeingänge, die mit Kleinsignalwandlern betrieben werden, sind beispielsweise in der Norm IEC 61869 festgelegt. Die Impedanzanpassungs-Schaltung 32 kann als resistiver Spannungsteiler aufgebaut sein und in diesem Zusammenhang beispielsweise einen oberen Widerstandswert von 1,8 MΩ und einen unteren Widerstandswert von 200kΩ aufweisen.

Der Impedanzanpassung-Schaltung 32 kann eine Signalaufbereitungseinheit 33 nachgeordnet sein. Die Signalaufbereitungeinheit 33 kann beispielsweise als Tiefpassfilter bzw. PI-Glied ausgestaltet sein. Bei einer Ausgestaltung als Tiefpassfilter kann es sich beispielsweise um eine R-C-Kombination aus einem Widerstand und einem Kondensator handeln, die einen Tiefpass erster Ordnung bildet, dessen Eckfrequenz unterhalb der Nennfrequenz der technischen Anlage festgelegt ist. Bei einer Ausgestaltung als PI-Glied kann z.B. ein Operationsverstärker in invertierender Grundschaltung mit einem Widerstand vom Eingang der Schaltung zum invertierenden OPV-Eingang und einem Widerstand parallel zu einem Kondensator im Rückkopplungszweig verwendet werden. Die Signalaufbereitungseinheit 33 kann beispielsweise zur Limitierung der frequenzabhängigen Verstärkung der analogen Signalkette innerhalb des genutzten Frequenzbereiches dienen. Die Signalaufbereitungseinheit 33 kann (z.B. über eine den Messeingang steuernde Software) zwischen zwei Modi umschaltbar sein, wobei der erste Modus eine Tiefpass-Charakteristik oder eine PI-Charakteristik und der zweite Modus eine proportionale Charakteristik aufweist. Die Umschaltung zwischen den beiden Modi dient dazu, ein differenzierendes Verhalten einer Rogowskispule bereits vor der Analog-Digital-Wandlung zu kompensieren. Dabei kann der Modus der Signalaufbereitungseinheit 33 in Abhängigkeit von der Lage einer Nullstelle der Übertragungsfunktion $g_{Sensor}(f)$ des Kleinsignalwandlers 11 festgelegt sein. Wenn die Übetragungsfunktion $g_{Sensor}(f)$ in der Nullstellen-Polstellen-Darstellung eine Nullstelle bei einer Frequenz von 0Hz aufweist, wie dies z.B. bei einer Rogowskispule der Fall ist, wird die Signalaufbereitungseinheit 33 im ersten Modus betrieben. Dies hat den Vorteil, dass der nachgeschaltete Analog-Digital-Wandler mit einer hohen Genauigkeit betrieben werden kann, da keine oder nur eine geringe Aussteuerungsreserve des AD Wandlers für transiente Impulsspitzen der Rogowskispule vorgehalten werden muss.

Der Signalaufbereitungseinheit 33 ist ein programmierbarer Verstärker 34 (Programmable Gain Amplifier - PGA) nachgeschaltet. Dieser dient zur anpassbaren Anhebung des Signallevels. Die Verstärkung $g_{PGA}$ des programmierbaren Verstärkers kann beispielsweise gemäß der folgenden Gleichung eingestellt werden:

$$g_{PGA} = \frac{V_{IO-inp-max}}{V_{ADC-max} \cdot g_{Div}}$$

$$V_{IO-inp-max} = \sqrt{2} \cdot g_{SigChain}(f_n) \cdot X_{Nom} \cdot Clip$$

Hierbei bedeuten:

$g_{SigChain}(f_n)$: Übertragungsfunktion des angeschlos-senen Kleinsignalwandlers (inkl. An-schlussleitung) gefaltet mit der Übertra-gungsfunktion der zumindest einen Baugruppe 22 des Messeingangs 14 bei der Nennfrequenz der technischen Anlage;

$X_{Nom}$: Nennspannung bzw. Nennstrom der technischen Anlage (abhängig vom Sensortyp);

Clip: Verhältnis zwischen dem Vollausschlag und dem Nennwert der Spannung bzw. des Stroms;

$V_{ADC-max}$: Vollausschlag der Eingangsspannung des Analog-Digital-Wandlers;

$g_{div}$: Übersetzungsverhältnis der Signalübertragungskette; Quotient aus der

Ausgangsspannung der Signalübertragungskette und des dabei anliegenden Eingangssignals (Strom oder Spannung je nach Sensor) bei Nennfrequenz.

Dem programmierbaren Verstärker 34 ist eine Abtasteinrichtung bzw. Analog-Digital-Wandler 35 nachgeschaltet, der das vom Verstärker 34 ausgangsseitig abgegebene Messsignal digitalisiert und über einen internen Bus an das Korrekturglied 22 (vgl. Figur 2) weiterleitet. Im Beispiel der Figur 3 bilden die Impedanzanpassungs-Schaltung 32, die Signalaufbereitungseinheit 33 und der programmierbare Verstärker 34 den Analogteil des Messeingangs 14 und damit die zumindest eine Baugruppe 21 gemäß Figur 2.

Das Korrekturglied 22 umfasst einen digitalen Filter 36 und einen Datenspeicher 37. In dem Datenspeicher 37 wird ein in Figur 3 schematisch angedeuteter Parametersatz 38 bereitgestellt, der die Filter-Übertragungsfunktion $g_{Filter}(f)$ des digitalen Filters bestimmt. Der Parametersatz ist hierbei variabel und kann auf die Art und Ausgestaltung des Kleinsignalwandlers 11, der Anschlussleitung 13 und der mindestens einen Baugruppe 21 des Messeingangs 14 spezifisch angepasst werden. Hierzu sind in dem Datenspeicher Modellbeschreibungen 39 hinterlegt, die die Übertragungsfunktionen $g_{Sensor}(f)$, $g_{Cable}(f)$ und $g_{Input}(f)$ der einzelnen Komponenten der Sensor-Übertragungsstrecke analytisch beschreiben. Alternativ können die Modellbeschreibungen 39 auch in einem Konfigurationswerkzeug, z.B. einer Kon-figurationssoftware, hinterlegt sein. Die Modellbeschrei-bungen geben die Modellierung von Zweipolen bzw. Vierpolen an, mit denen die Übertragungsfunktionen der Komponenten "Kleinsignalwandler", "Anschlussleitung" und "Baugruppe des Messeingangs" beschrieben werden können. Diese Modellbeschreibungen greifen auf für die jeweiligen Kleinsignalwandlertypen, An-schlussleitungstypen und Baugruppentypen des Mes-seingangs vordefinierten Ersatzschaltungen und deren Parameter zurück, um das frequenzabhängige Übertragungsverhalten zu beschreiben. Dabei werden die Ersatzschaltungen der einzelnen Vierpole z.B. in einer Kettenmatrixdarstellung eines Vierpols mit Hilfe von vier einzelnen Übertragungsfunktionen modelliert. Die Übertragungsfunktionen der Kettenmatrixelemente werden dabei in bekannter Weise durch Koeffizientenvergleich aus der jeweiligen Ersatzschaltung des Vierpols ermittelt. Aus der Verknüpfung der einzelnen modellierten Übertragungsfunktionen lässt sich die Sensorstrecken-Übertragungsfunktion $g_{total}(f)$ bestimmen, zu deren Korrektur die Filter-Übertragungsfunktion $g_{Filter}(f)$ ausgelegt ist. Die Art der Verknüpfung kann beispielsweise durch Multiplikation der Kettenmatritzen der einzelnen in Serie geschalteten Vierpole erfolgen.Aus den resultierenden Kettenmatrixelementen kann dann in bekannter Weise die Ausgangsspannungs- zu Eingangsspannungs- oder Ausgangsspannungs- zu Eingangsstrom-Übertragungsfunktion (je nach Sensortyp) des resultierenden Vierpols bei Vorgabe der Übertragungsfunktion der Lastimpedanz des Vierpols gebildet werden.

Dabei kann die aus der Überlagerung der Sensorstrecken-Übertragungsfunktion $g_{total}(f)$ und der Filter-Übertragungsfunktion $g_{Filter}(f)$ resultierende Übertragungsfunktion $g_{result}(f)$ derart gewählt werden, dass sie einer Übertragungscharakteristik entsprechen würde, die beim Anschluss eines herkömmlichen induktiven Strom- bzw. Spannungswandlers an einen herkömmlichen Messeingang vorliegen würde. Dies ermöglicht es, dass dem Messeingang 14 nachgelagerte Auswertungsfunktionen des elektrischen Gerätes 10, die bisher auf die Verwendung von induktiven Wandlern ausgelegt waren und an deren Charakteristiken angepasst waren, unverändert beibehalten werden können. Natürlich ist auch jede andere Form der resultierenden Übertragungsfunktion möglich, so dass beispielsweise auch komplett flache Verläufe der resultierenden Übertragungsfunktion realisiert werden können. Zur Berechnung der korrigierenden Filter-Übertragungsfunktion anhand der Sensorstrecken-Übertragungsfunktion wird die Sensorstrecken-Übertragungsfunktion in vorteilhafter Weise mithilfe einer Eigenwert-Berechnung der charakteristischen Matrix des Übertragungsfunktions-Polynoms in eine Produktform transformiert (sogenannte "Zero, Pole Gain-Darstellung"). Die Pol- und Nullstellen der Sensorstrecken-Übertragungsfunktion werden nach ihrer Frequenz sortiert. Es werden nur Pol- und Nullstellen betrachtet, die im für eine Korrektur interessierenden Frequenzbereich liegen (Typischerweise der Frequenzbereich von 0 Hz bis zur halben Abtastfrequenz des AD Wandlers). Um nach der Korrektur eine möglichst flache resultierende Gesamt-Übertragungsfunktion zu erzielen, werden Nullstellen der Sensorstrecken-Übertragungsfunktion im interessierenden Frequenzbereich als Polstellen in der Filter-Übertragungsfunktion sowie die Polstellen der Sensorstrecken-Übertragungsfunktion als Nullstellen der Filter-Übertragungsfunktion verwendet. Die Verstärkung ("Gain") der Filter-Übertragungsfunktion wird so gewählt, dass das Produkt der Verstärkungen der Sensorstrecken-Übertragungsfunktion und der Filter-Übertragungsfunktion bei Nennfrequenz dem gewünschten Wert entspricht (z.B. 1,0 mal Nennwert). Zur Anpassung der Filter-Übertragungsfunktion an eine vorgegebene Referenz-Charakteristik eines induktiven Wandlers werden die Pol- und Nullstellen der Referenz-Charakteristik in die Filter-Übertragungsfunktion der flachen Charakteristik als zusätzliche Produkt-Terme eingefügt.

Figur 4 zeigt ein elektrisches Gerät 40, das einerseits mittels eines Messeingangs 14 an einen Kleinsignalwandler 11 und mittels eines weiteren (herkömmlichen) Messeingangs 41 an einen induktiven Wandler angeschlossen ist. Insbesondere bei einer solchen Mischkonfiguration ist es von Vorteil, wenn die resultierende Übertragungsfunktion des Messeingangs 14 derart ausgelegt ist, dass sie der Charakteristik einer Übertragungsstrecke mit induktivem Wandler entspricht.

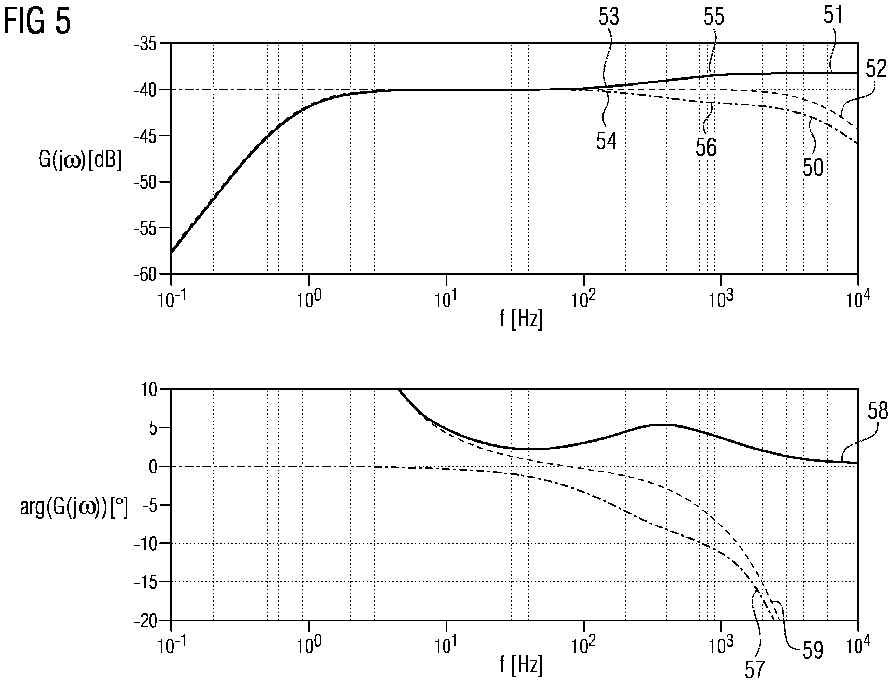

Figur 5 zeigt schließlich Diagramme mit beispielhaften Verläufen von Übertragungsfunktionen bei Verwendung eines Kleinsignalwandlers in Form eines R-C-Teilers zur Spannungsmessung. Dabei zeigt das obere Diagramm die Übertragungsfunktionen der Amplitude und das untere Diagramm die Übertragungsfunktion des Phasenwinkels. Im oberen Diagramm erkennt man als Kurve 50 die Sensorstrecken-Übertragungsfunktion $g_{total}(f)$ bei Verwendung des R-C-Teilers. Kurve 51 gibt die korrigierende Filter-Übertragungsfunktion $g_{Filter}(f)$ des digitalen Filters an, die verwendet werden muss, um die gewünschte resultierende Gesamt-Übertragungsfunktion $g_{result}(f)$ zu erreichen, die als Kurve 52 gezeigt ist. Man erkennt, dass in einer Nullstellen-Polstellen-Darstellung der Übertragungsfunktion zur Auslegung der Filter-Übertragungsfunktion Abhängigkeiten zwischen Nullstellen und Polstellen der Filter-Übertragungsfunktion $g_{Filter}(f)$ und der Sensorstrecken-Übertragungsfunktion $g_{total}(f)$ geschaffen werden müssen.

Beispielsweise kann vorgesehen sein, dass in einem Frequenzbereich zwischen 0Hz und der halben Abtastfrequenz $f_a$ des A-D-Wandlers die Polstellen der Filter-Übertragungsfunktion (z.B. Stelle 53 in Figur 5) an den Nullstellen der Sensorstrecken-Übertragungsfunktion (z.B. Stelle 54 in Figur 5) liegen und umgekehrt die Nullstellen der Filter-Übertragungsfunktion (z.B. Stelle 55 in Figur 5) an den Polstellen der Sensorstrecken-Übertragungsfunktion (z.B. Stelle 56 in Figur 5) liegen.

Im Falle einer Rogowskispule wird eine Nullstelle der Sensorstrecken-Übertragungsfunktion bei f=0Hz mit einer Polstelle der Filter-Übertragungsfunktion bei einer Frequenz kompensiert, die einer Zeitkostanten eines herkömmlichen induktiven Strom- bzw. Spannungswandlers entspricht.

Im Falle anderer Wandlertypen, bei denen keine Nullstelle bei 0Hz vorliegt, wird in der Filter-Übertragungsfunktion eine zusätzliche Polstelle bei einer Frequenz eingefügt, die einer Zeitkostanten eines herkömmlichen induktiven Strom- bzw. Spannungswandlers entspricht.

Im unteren Diagramm gibt hinsichtlich der Phasendrehung die Kurve 57 die Sensorstrecken-Übertragungsfunktion bei einem Kleinsignalwandler in Form eines R-C-Teilers, die Kurve 58 die korrigierende Filter-Übertragungsfunktion und die Kurve 59 die resultierende Gesamt-Übertragungsfunktion an.

Der Messeingang 14 ist dazu ausgebildet, mit jedem beliebigen Typ eines Kleinsignalwandlers zusammenzuwirken und als resultierende Übertragungsfunktion die gewünschte Charakteristik aufzuweisen. Dazu muss lediglich der in dem Datenspeicher 37 vorhandene Parametersatz 38 wie oben erläutert an den Kleinsignalwandler angepasst werden. Dies erfolgt im Rahmen einer Konfiguration. Dazu können aus den Modellen 39 für die Komponenten der Messstrecke die erforderlichen Informationen über die einzelnen Übertragungsfunktionen ermittelt werden. Dies kann direkt in dem Messeingang oder in einem externen Konfigurationswerkzeug erfolgen. Im letztgenannten Fall sind die Modellbeschreibungen anstelle in dem Messeingang im Konfigurationswerkzeug gespeichert. Der gewonnene Parametersatz berücksichtigt auch die Übertragungscharakteristik der Anschlussleitung, die sich insbesondere aus deren Art und Länge ermittelt. Die Konfiguration kann vor Inbetriebnahme des Messeingangs erfolgen. Auch können Standardeinstellungen für verschiedene Typen und Bauweisen von Kleinsignalwandlern bereits berechnet und hinterlegt (z.B. im Datenspeicher des Messeingangs) sein, so dass zur Konfiguration lediglich eine Auswahl des korrekten Typs des Kleinsignalwandlers erfolgen muss.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Messeingang (14) zum Anschluss eines Kleinsignalwandlers (11) an ein elektrisches Gerät (10) mit

   - einem elektrischen Eingang (30) zum Anschließen einer Anschlussleitung (13) des Kleinsignalwandlers (11);
   - einem elektrischen Ausgang (31) zur Ausgabe eines Messignals an das elektrische Gerät (10); und
   - einem Korrekturglied (22), das einen digitalen Filter (36) aufweist, dessen Filter-Übertragungsfunktion an den Kleinsignalwandler (11) angepasst ist;

   wobei

   - die Filter-Übertragungsfunktion des Korrekturglieds (22) mittels eines Parametersatzes (38) festgelegt ist, wobei der Parametersatz (38) spezifisch für den Kleinsignalwandler (11) variabel vorgebbar ist,

   **dadurch gekennzeichnet, dass**

   - der Parametersatz (38) spezifisch für verschiedene Typen von Kleinsignalwandlern (11) einerseits zur Strommessung und andererseits zur Spannungsmessung vorgebbar ist.

2. Messeingang (14) nach Anspruch 1,
   **dadurch gekennzeichnet, dass**

   - die Filter-Übertragungsfunktion des Korrekturglieds (22) zur Kompensation einer Sensorstrecken-Übertragungsfunktion einer durch den Kleinsignalwandler (11), die Anschlussleitung (13) und zumindest eine Baugruppe (21) des Messeingangs (14) gebildeten Übertragungsstrecke ausgebildet ist.

3. Messeingang (14) nach einem der vorangehenden Ansprüche,
   **dadurch gekennzeichnet, dass**

   - die Filter-Übertragungsfunktion derart ausgebildet ist, dass eine aus der Überlagerung der Sensorstrecken-Übertragungsfunktion und der Filter-Übertragungsfunktion resultierende Gesamt-Übertragungsfunktion einer Übertragungscharakteristik entspricht, die bei Verwendung eines induktiven Wandlers als Sensor vorliegen würde.

4. Messeingang (14) nach einem der vorangehenden Ansprüche,
   **dadurch gekennzeichnet, dass**

   - die Polstellen der Filter-Übertragungsfunktion in Abhängigkeit der Lage der Nullstellen der Sensorstrecken-Übertragungsfunktion und die Nullstellen der Filter-Übertragungsfunktion in Abhängigkeit der Lage der Polstellen der Sensorstrecken-Übertragungsfunktion festgelegt sind.

5. Messeingang (14) nach einem der vorangehenden Ansprüche,

   - der Parametersatz (38) in einem Datenspeicher (37) im Rahmen einer Konfiguration des Messeingangs (14) abgespeichert ist.

6. Messeingang (14) nach Anspruch 6,
   **dadurch gekennzeichnet, dass**

   - im Datenspeicher (37) des Messeingangs oder in einem Konfigurationswerkzeug zur Konfiguration ein den Kleinsignalwandler (11) beschreibendes Sensormodell, ein die Anschlussleitung (13) beschreibendes Kabelmodell und ein zumindest eine Baugruppe (21) des Messeingangs (14) beschreibendes Messeingangsmodell bereitgestellt sind, aus denen der Parametersatz (38) abgeleitet wird.

7. Messeingang (14) nach einem der vorangehenden Ansprüche,
   **dadurch gekennzeichnet, dass**

   - dem elektrischen Eingang (30) eine Impedanzanpassungs-Schaltung (32) nachgeordnet ist, die als Spannungsteiler ausgebildet ist.

**8.** Messeingang (14) nach Anspruch 7, **dadurch gekennzeichnet, dass**

> - der Impedanzanpassungs-Schaltung (32) eine Signalaufbereitungseinheit (33) nachgeschaltet ist, die zwischen einem ersten Modus gemäß einer Tiefpass-Charakteristik oder einem PI-Glied und einem zweiten Modus gemäß einer proportionalen Charakteristik umschaltbar ist.

**9.** Messeingang (14) nach Anspruch 8, **dadurch gekennzeichnet, dass**

> - der Modus der Signalaufbereitungseinheit (33) in Abhängigkeit von der Lage einer Nullstelle der Übertragungsfunktion des Kleinsignalwandlers (11) festgelegt ist.

**10.** Messeingang (14) nach Anspruch 9, **dadurch gekennzeichnet, dass**

> - der Signalaufbereitungseinheit (33) ein programmierbarer Verstärker (34) nachgeschaltet ist.

**11.** Messeingang (14) nach Anspruch 10, **dadurch gekennzeichnet, dass**

> - dem programmierbaren Verstärker (34) eine Abtasteinrichtung (35) nachgeschaltet ist.

**12.** Elektrisches Gerät (10) mit zumindest einem Messeingang (14) nach einem der vorangehenden Ansprüche.

**13.** Elektrisches Gerät (10) nach Anspruch 12, **dadurch gekennzeichnet, dass**

> - das elektrische Gerät ein Mess-, Steuer- oder Schutzgerät einer technischen Anlage ist.

**14.** Elektrisches Gerät nach Anspruch 12 oder 13, **dadurch gekennzeichnet, dass**

> - das elektrische Gerät außer dem zumindest einen Messeingang (14) zumindest einen weiteren Messeingang (41) zum Anschluss eines induktiven Wandlers (42) aufweist.

**Claims**

**1.** Measurement input (14) for connecting a small signal transformer (11) to an electrical device (10), having

> - an electrical input (30) for connecting a connection line (13) of the small signal transformer (11);
> - an electrical output (31) for outputting a measurement signal to the electrical device (10); and
> - a correction element (22) which has a digital filter (36), the filter transfer function of which is adapted for the small signal transformer (11);

wherein

> - the filter transfer function of the correction element (22) is defined by means of a parameter set (38), wherein the parameter set (38) is able to be variably preset specifically for the small signal transformer (11),

**characterized in that**

> - the parameter set (38) is able to be preset specifically for different types of small signal transformers (11) on the one hand for current measurement and on the other hand for voltage measurement.

**2.** Measurement input (14) according to Claim 1, **characterized in that**

> - the filter transfer function of the correction element (22) is designed for compensating a sensor path transfer function of a transfer path formed by the small signal transformer (11), the connection line (13) and at least one assembly (21) of the measurement input (14).

**3.** Measurement input (14) according to either of the preceding claims, **characterized in that**

> - the filter transfer function is designed in such a way that a total transfer function resulting from the superposition of the sensor path transfer function and the filter transfer function corresponds to a transfer characteristic which would be present when using an inductive transformer as a sensor.

**4.** Measurement input (14) according to one of the preceding claims, **characterized in that**

> - the pole points of the filter transfer function are defined depending on the position of the zero points of the sensor path transfer function and the zero points of the filter transfer function depending on the position of the pole points of the sensor path transfer function.

**5.** Measurement input (14) according to one of the preceding claims,

- the parameter set (38) is stored in a data storage device (37) in the context of a configuration of the measurement input (14).

6. Measurement input (14) according to Claim 6, **characterized in that**

    - a sensor model describing the small signal transformer (11), a cable model describing the connection line (13) and a measurement input model describing at least one assembly (21) of the measurement input (14) are provided, from which the parameter set (38) is derived, in the data storage device (37) of the measurement input or in a configuration tool for configuration.

7. Measurement input (14) according to one of the preceding claims, **characterized in that**

    - an impedance matching circuit (32), which is designed as a voltage divider, is connected downstream of the electrical input (30).

8. Measurement input (14) according to Claim 7, **characterized in that**

    - a signal conditioning unit (33), which is able to be switched between a first mode according to a low-pass characteristic or a PI element and a second mode according to a proportional characteristic, is connected downstream of the impedance matching circuit (32).

9. Measurement input (14) according to Claim 8, **characterized in that**

    - the mode of the signal conditioning unit (33) is defined depending on the position of a zero point of the transfer function of the small signal transformer (11).

10. Measurement input (14) according to Claim 9, **characterized in that**

    - a programmable gain amplifier (34) is connected downstream of the signal conditioning unit (33).

11. Measurement input (14) according to Claim 10, **characterized in that**

    - a scanning device (35) is connected downstream of the programmable gain amplifier (34).

12. Electrical device (10) having at least one measurement input (14) according to one of the preceding claims.

13. Electrical device (10) according to Claim 12, **characterized in that**

    - the electrical device is a measurement, control or protection device of a technical system.

14. Electrical device according to Claim 12 or 13, **characterized in that**

    - the electrical device, in addition to the at least one measurement input (14), has at least one further measurement input (41) for connecting an inductive transformer (42).

**Revendications**

1. Entrée (14) de mesure pour le raccordement d'un petit convertisseur (11) de signal à un appareil (10) électrique comprenant

    - une entrée (30) électrique de raccordement d'une ligne (13) de raccordement du petit convertisseur (11) de signal,
    - une sortie (31) électrique pour envoyer un signal de mesure à l'appareil (10) électrique ; et
    - un élément (22) de correction, qui a un filtre (36) numérique, dont la fonction de transfert de filtre est adaptée au petit convertisseur (11) de signal ;

    dans laquelle

    - la fonction de transfert de filtre de l'élément (22) de correction est déterminée au moyen d'un ensemble (38) de paramètres, dans laquelle l'ensemble (38) de paramètres peut être prescrit de manière variable spécifiquement pour le petit convertisseur (11) de signal,

    **caractérisée en ce que**

    - l'ensemble (38) de paramètre peut être prescrit spécifiquement pour divers types de petits convertisseurs (11) de signal d'une part pour la mesure du courant et d'autre part pour la mesure de la tension.

2. Entrée (14) de mesure suivant la revendication 1, **caractérisée en ce que**

    - la fonction de transfert de filtre de l'élément (22) de correction est constituée pour la compensation d'une fonction de transfert de section de capteur d'une section de transfert formée par le petit convertisseur (11) de signal, la ligne (13) de raccordement et au moins un module (21) de l'entrée (14) de mesure.

**3.** Entrée (14) de mesure suivant l'une des revendications précédentes, **caractérisée en ce que**

- la fonction de transfert de filtre est constituée de manière à ce qu'une fonction de transfert d'ensemble, résultant de la superposition de la fonction de transfert de section de capteur et de la fonction de transfert de filtre, corresponde à une caractéristique de transfert, qui aurait été présente, si l'on avait utilisé un convertisseur inductif comme capteur.

**4.** Entrée (14) de mesure suivant l'une des revendications précédentes, **caractérisée en ce que**

- les points polaires de la fonction de transfert de filtre sont déterminés en fonction de la position des points zéro de la fonction de transfert de section de capteur et les points zéro de la fonction de transfert de filtre en fonction de la position des points polaires de la fonction de transfert de section de capteur.

**5.** Entrée (14) de mesure suivant l'une des revendications précédentes,

- l'ensemble (38) de paramètres est mis dans une mémoire (37) de données, dans le cadre d'une configuration de l'entrée (14) de mesure.

**6.** Entrée (14) de mesure suivant la revendication 5, **caractérisée en ce que**

- sont mis à disposition, dans la mémoire (37) de données de l'entrée de mesure ou d'un outil de configuration pour la configuration d'un modèle de capteur décrivant le petit convertisseur (11) de signal, un modèle de câble décrivant la ligne (13) de raccordement et un modèle d'entrée de mesure décrivant au moins un module (21) de l'entrée (14) de mesure, à partir desquels l'ensemble (38) de paramètres est déduit.

**7.** Entrée (14) de mesure suivant l'une des revendications précédentes, **caractérisée en ce que**,

- en aval de l'entrée (30) électrique, est monté un circuit (32) d'adaptation d'impédance, qui est constitué sous la forme d'un diviseur de tension.

**8.** Entrée (14) de mesure suivant la revendication 7, **caractérisée en ce que**,

- en aval du circuit (32) d'adaptation d'impédance, est montée une unité (33) de traitement du signal, qui peut commuter entre un premier mode suivant une caractéristique passe bas ou un élément PI et un deuxième mode suivant les caractéristiques proportionnelles.

**9.** Entrée (14) de mesure suivant la revendication 8, **caractérisée en ce que**

- le mode de l'unité (33) de traitement du signal est déterminé en fonction de la position d'un point zéro de la fonction de transfert du petit convertisseur (11) de signal.

**10.** Entrée (14) de mesure suivant la revendication 9, **caractérisée en ce qu'**

- un amplificateur (34) programmable est monté en aval de l'unité (33) de traitement du signal.

**11.** Entrée (14) de mesure suivant la revendication 10, **caractérisée en ce qu'**

- un dispositif (35) d'étalonnage est monté en aval de l'amplificateur (34) programmable.

**12.** Appareil (10) électrique ayant au moins une entrée (14) de mesure suivant l'une des revendications précédentes.

**13.** Appareil (10) électrique suivant la revendication 12, **caractérisé en ce que**

- l'appareil électrique est un appareil de mesure de commande ou de protection d'une installation technique.

**14.** Appareil (10) électrique suivant la revendication 12 ou 13, **caractérisé en ce que**

- l'appareil électrique a, outre la au moins une entrée (14) de mesure, au moins une autre entrée (41) de mesure pour le raccordement d'un convertisseur (42) inductif.

## FIG 1

## FIG 2

$g_{Sensor}(f)$  $g_{Cable}(f)$  $g_{Input}(f)$  $g_{Filter}(f)$

$g_{total}(f)$

# FIG 3

# FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10346356 A1
- US 9917662 B2
- US 2019383859 A1